# DEMANDE DE BREVET EUROPEEN

(11) **EP 4 553 889 A1**
(43) Date de publication de la demande: **14.05.2025**
(21) Numéro de dépôt: 24209690.7
(22) Date de dépôt: 30.10.2024
(51) Int. Cl.: H01L 21/28, H10B 53/30, H10B 80/00, H10D 1/68

(54) **DISPOSITIF ELECTRONIQUE**

(30) Priorité: 09.11.2023 GR 20230100929; 09.11.2023 FR 2312188
(71) Demandeur: Commissariat à l'Energie Atomique et aux Energies Alternatives, 75015 Paris (FR)
(72) Inventeur: KERDILES, Sébastien, 38054 GRENOBLE CEDEX 09 (FR); BARLAS, Marios, 38000 GRENOBLE (FR); GRENOUILLET, Laurent, 38054 GRENOBLE CEDEX 09 (FR); OPPRECHT, Mathieu, 38054 GRENOBLE CEDEX 09 (FR)
(74) Mandataire: Cabinet Beaumont

(57) **Abrégé**

La présente description concerne un procédé de fabrication d'un dispositif électronique (10), le procédé comprenant :
- la formation d'un support (12) comprenant au moins une première couche isolante (12a) et des pistes conductrices (14) ;
- la formation d'une deuxième couche isolante (18) ;
- la formation de cavités (20) dans la deuxième couche isolante (18) ; et
- la formation d'une cellule mémoire dans un premier emplacement comprenant :
o la formation d'un empilement de couches s'étendant sur les parois et le fond des cavités (20), l'empilement comprenant une couche (26) en un matériau apte à devenir ferroélectrique situé entre une première couche conductrice (24) et une deuxième couche conductrice (28), ; et
o l'application d'un laser sur l'empilement de couches à au moins le premier emplacement de sorte à activer des propriétés ferromagnétiques de la couche (26).

## Description

### Domaine technique

La présente description concerne de façon générale les dispositifs électroniques et plus particulièrement les dispositifs mémoire.

### Technique antérieure

On appelle ferroélectricité la propriété selon laquelle un matériau possède une polarisation électrique à l'état spontané, polarisation qui peut être renversée par l'application d'un champ électrique extérieur. La signature d'un matériau ferroélectrique est le cycle d'hystérésis de la polarisation en fonction du champ électrique appliqué.

### Résumé de l'invention

Un mode de réalisation prévoit un procédé de fabrication d'un dispositif électronique, le procédé comprenant : la formation d'un support comprenant au moins une première couche isolante dans laquelle sont situées des pistes conductrices ; la formation d'une deuxième couche isolante sur le support ; la formation de cavités dans la deuxième couche isolante ; et la formation d'une cellule mémoire dans un premier emplacement comprenant : la formation d'un empilement de couches, l'empilement s'étendant sur les parois et le fond des cavités, l'empilement comprenant une couche en un matériau apte à devenir ferroélectrique situé entre une première couche conductrice et une deuxième couche conductrice, la formation de l'empilement comprenant la formation des première et deuxième couches conductrices et d'une couche diélectrique entre les première et deuxième couches conductrices ; l'application d'un laser sur l'empilement de couches à au moins le premier emplacement de sorte à activer des propriétés ferroélectriques de la couche en un matériau apte à devenir ferroélectrique ; la formation d'une couche recouvrant la deuxième couche conductrice, ladite couche étant : une couche protectrice, l'étape d'application du laser étant effectuée après la formation de la couche protectrice ; ou une troisième couche conductrice, la troisième couche conductrice remplissant les cavités.

Selon un mode de réalisation, le laser est appliqué uniquement sur le premier emplacement.

Selon un mode de réalisation, le laser est appliqué à l'ensemble du dispositif, des portions de la deuxième couche conductrice entourant le premier emplacement étant protégées, lors de l'application du laser, par un masque de protection.

Selon un mode de réalisation, lors de l'application du laser, la couche diélectrique est entièrement recouverte par la deuxième couche conductrice.

Selon un mode de réalisation, la couche protectrice est transparente à la longueur d'onde du laser.

Selon un mode de réalisation, la deuxième couche conductrice a une épaisseur strictement supérieure à 1 nm, par exemple supérieure ou égale à 3 nm, par exemple comprise entre 3 nm et 20 nm, la deuxième couche étant en un matériau autorisant l'absorption entière de l'énergie du laser de manière à chauffer la couche diélectrique par diffusion.

Selon un mode de réalisation, la couche diélectrique est chauffée à une température supérieure à 500 °C.

Selon un mode de réalisation, le laser est appliqué par impulsion d'une durée inférieure à 1 ps.

Selon un mode de réalisation, le laser a une longueur d'onde inférieure à 400 nm.

Selon un mode de réalisation, le procédé comprend la fabrication d'au moins un condensateur dans un deuxième emplacement, le condensateur comprenant les première et deuxième couches conductrices et la couche diélectrique, le laser n'étant pas appliqué à la couche diélectrique dans le deuxième emplacement.

Selon un mode de réalisation, les parois latérales des cavités sont penchées et forment chacune un angle compris entre 0,5° et 5 ° avec une direction orthogonale au plan du fond des cavités.

Selon un mode de réalisation, la couche en un matériau ferroélectrique est en oxyde d'hafnium ou en HzZrO2.

Selon un mode de réalisation, la couche en un matériau ferroélectrique est en oxyde d'hafnium dopé par du silicium, la proportion de silicium étant comprise entre 0,5 % et 5%.

Selon un mode de réalisation, la première couche conductrice est en nitrure de titane dopé silicium.

Un autre mode de réalisation prévoit un dispositif électronique comprenant : un support comprenant au moins une première couche isolante dans laquelle sont situées des pistes conductrices, et une deuxième couche isolante comprenant des cavités ; une cellule mémoire comprenant un empilement de couches, l'empilement s'étendant sur les parois et le fond des cavités, l'empilement comprenant une couche en un matériau ferroélectrique située entre une première couche conductrice et une deuxième couche conductrice, la deuxième couche conductrice étant continue et entièrement métallique ; et une couche recouvrant la deuxième couche conductrice, ladite couche étant : une couche protectrice ; ou une troisième couche conductrice, la troisième couche conductrice remplissant les cavités.

Selon un mode de réalisation, le dispositif comprend un condensateur comprenant un empilement de couches, l'empilement s'étendant sur les parois et le fond des cavités, l'empilement comprenant une couche en un matériau apte à devenir ferroélectrique située entre une première couche conductrice et une deuxième couche conductrice, la deuxième couche conductrice étant continue et entièrement métallique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente une vue en perspective d'un mode de réalisation d'un dispositif électronique ;
la figure 1B représente une vue en coupe d'un mode de réalisation du dispositif électronique de la figure 1A ;
la figure 1C représente une vue en coupe d'un mode de réalisation du dispositif électronique de la figure 1A ;
la figure 2 représente une étape d'un procédé de fabrication du mode de réalisation des figures 1A, 1B et 1C ;
la figure 3 représente une autre étape d'un procédé de fabrication du mode de réalisation des figures 1A, 1B et 1C ;
la figure 4 représente une autre étape d'un procédé de fabrication du mode de réalisation des figures 1A, 1B et 1C ;
la figure 5 représente une autre étape d'un procédé de fabrication du mode de réalisation des figures 1A, 1B et 1C ;
la figure 6 représente une autre étape d'un procédé de fabrication du mode de réalisation des figures 1A, 1B et 1C ;
la figure 7 représente une autre étape d'un procédé de fabrication du mode de réalisation des figures 1A, 1B et 1C ;
la figure 8 représente une autre étape d'un procédé de fabrication du mode de réalisation des figures 1A, 1B et 1C ;
la figure 9 représente schématiquement une vue de dessus d'un dispositif tel que le dispositif des figures 1A, 1B et 1C ;
la figure 10 représente un autre mode de réalisation d'un dispositif électronique ; et
la figure 11 représente un autre mode de réalisation d'un dispositif électronique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

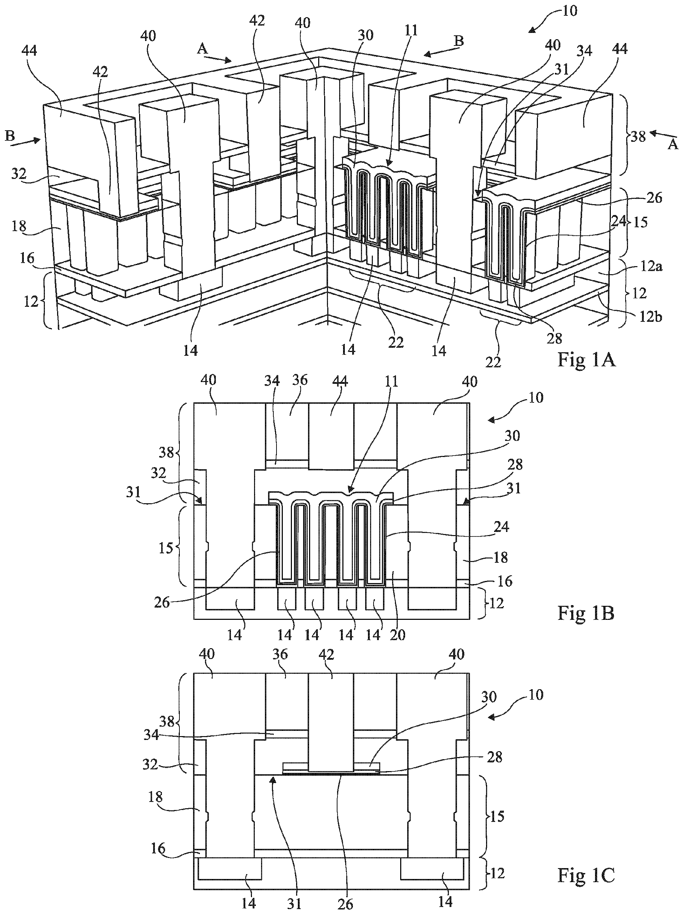

Les figures 1A, 1B et 1C représentent un mode de réalisation d'un dispositif électronique 10, comprenant au moins une cellule mémoire 11, dans l'exemple des figures 1A, 1B, et 1C, une unique cellule 11. Plus précisément, la figure 1A représente une vue en perspective du dispositif 10. La figure 1B représente une vue en coupe du dispositif 10 selon un plan A-A. La figure 1C représente une vue en coupe du dispositif 10 selon un plan B-B.

La cellule mémoire 11 est une cellule de type ferroélectrique. Autrement dit, la cellule contient une valeur programmée par une polarisation électrique. Par exemple, le dispositif comprend une pluralité de cellules mémoire telles que la cellule 11, par exemple agencés en matrice. La cellule 11 est une cellule mémoire non volatile.

Le dispositif 10 comprend un substrat, ou support, 12. Le support 12 est par exemple un empilement de couches isolantes 12a et 12b. Par exemple, l'empilement 12 comprend une alternance de couches 12a et 12b. Les couches 12a sont par exemple des couches d'oxyde de silicium. Les couches 12b sont par exemple des couches de nitrure de silicium.

Au moins certaines des couches du support 12 comprennent des pistes conductrices 14 en cuivre. En particulier, dans l'exemple des figures 1A, 1B et 1C, des pistes 14 sont situées dans la couche supérieure du support, c'est-à-dire la couche la plus proche de la cellule 11. Les pistes 14 de ladite couche supérieure sont de préférence situées de manière à affleurer la face supérieure de la couche supérieure du support 12.

Le support 12, en particulier la face supérieure de la couche supérieure du support 12, est par exemple recouvert par un empilement 15 de couches isolantes. L'empilement 15 comprend, dans l'exemple des figures 1A, 1B et 1C, une couche isolante 16 et une couche isolante 18. La couche 16 est par exemple en nitrure de silicium. La couche 16 est par exemple en le même matériau que les couches 12b. La couche 18 est par exemple en oxyde de silicium. La couche 18 est par exemple en le même matériau que les couches 12a.

La couche 16 est la couche inférieure de l'empilement 15. La couche 18 est la couche supérieure de l'empilement 15. La couche 16 est par exemple en contact avec la face supérieure de la couche supérieure du support 12. La couche 18 est par exemple en contact avec la face supérieure de la couche 16.

L'empilement 15 est traversé par au moins une ouverture, ou cavité, 20, de préférence par une pluralité de cavités 20. Dans l'exemple des figures 1A, 1B et 1C, l'empilement 15 comprend une pluralité de lignes parallèles de cavités 20. Lesdites lignes de cavités 20 s'étendent dans la direction orthogonale au plan de coupe de la figure 1B. Par exemple, l'empilement 15 comprend des groupes 22 de lignes de cavités 20. Dans l'exemple des figures 1A, 1B et 1C, chaque groupe 22 comprend quatre lignes de cavités 20. Les lignes de cavités 20 d'un même groupe 22 sont par exemple séparées les unes des autres par sensiblement la même distance. Autrement dit, chaque ligne d'un groupe 22 est séparée des lignes voisines d'un même groupe par la même distance. Les distances séparant les lignes de cavités 20 d'un groupe 22 sont par exemple sensiblement égales dans tous les groupes 22. Les groupes 22 sont par exemple tous séparés les uns des autres par une même distance. La distance séparant chaque groupe 22 est de préférence supérieure à la distance séparant les lignes d'un même groupe 22.

Chaque cavité 20 traverse l'empilement 15, c'est-à-dire dans l'exemple des figures 1A, 1B et 1C, les couches 16 et 18. Autrement dit, les cavités 20 s'étendent de la face supérieure de la couche 18 jusqu'à la face inférieure de la couche 16. Chaque cavité 20 s'étend de manière à découvrir au moins une piste 14.

Chaque cavité 20 a par exemple une hauteur, correspondant à la somme des épaisseurs des couches 16 et 18, par exemple comprise entre 0,5 et 1,5 µm, par exemple sensiblement égale à 1 µm. Les dimensions horizontales de chaque cavité 20, c'est-à-dire les dimensions dans le plan de la face supérieure de la couche 18, sont par exemple comprises entre 50 nm et 150 nm, par exemple sensiblement égales à 100 nm.

La cellule 11 comprend des couches 24. Chaque couche 24 est située dans une cavité 20. Chaque cavité 20 comprend une couche 24. Il y a donc de préférence autant de couche 24 que de cavités 20.

Chaque couche 24 recouvre les parois latérales de la cavité 20 dans laquelle elle se trouve, autrement dit les parois des couches 16 et 18 situées au niveau de la cavité. Chaque couche 24 recouvre la portion du support 12 découvert par la cavité dans laquelle elle se trouve. Autrement dit, chaque couche 24 recouvre la portion de la piste 14 découverte par la cavité dans laquelle elle se trouve et éventuellement une portion de la couche 12a dans laquelle se trouve la piste 14. Toutes les portions des pistes 14 découvertes par les cavités 20 sont recouvertes par une couche 24. De préférence, la couche 24 ne s'étend pas en dehors de la cavité 20. Ainsi, la couche 24 ne s'étend de préférence pas sur les parois inférieure et supérieure des couches de l'empilement 15.

Chaque couche 24 est par exemple en nitrure de titane dopé de silicium. De préférence, le pourcentage de silicium dans le matériau de chaque couche 24 est de préférence inférieur à 20 %, par exemple compris entre 10 % et 20 %.

Les couches 24 de la cellule 11 sont par exemple reliées électriquement les unes aux autres par des pistes 14 du support 12. Les couches 24 constituent une première électrode de la cellule 11.

La cellule 11 comprend en outre une couche 26. La couche 26 est une couche ferroélectrique. La couche 26 est par exemple en un oxyde, par exemple en oxyde d'hafnium (HfO2) dopé par du silicium, par exemple avec une proportion de silicium comprise entre 0,5 % et 5%. La couche 26 peut, alternativement, être en HfZrO2. A titre de variante, la couche 26 est par exemple un empilement de couches ferroélectriques.

La couche 26 recouvre, de préférence entièrement, les couches 24. La couche 26 recouvre par exemple au moins une portion de la face supérieure de la couche 18. De préférence, les portions de la couche 26 situées dans les cavités 20, c'est-à-dire les portions recouvrant les couches 24, sont reliées les unes aux autres par des portions de la couche 26 situées sur la face supérieure de la couche 18.

La cellule 11 comprend en outre une couche 28 conductrice, par exemple en métal. La couche 28 est de préférence une couche continue et entièrement métallique. La couche 28 est par exemple en nitrure de titane, en nitrure de tantale ou en silicium polycristallin dopé. La couche 28 constitue la deuxième électrode de la cellule 11. La couche 28 a par exemple une épaisseur strictement supérieure à 1 nm, par exemple supérieure ou égale à 3 nm, par exemple comprise entre 3 nm et 20 nm.

La couche 28 recouvre, de préférence entièrement, la couche 26. La couche 28 s'étend donc sur les portions de la couche 26 recouvrant les parois des cavités 20, sur les portions de la couche 26 recouvrant les portions découvertes des pistes 14 et de l'empilement 12, et sur les portions de la couche 26 recouvrant la face supérieure de la couche 18. De préférence, la couche 28 recouvre uniquement la couche 26. Ainsi, la couche 28 n'est de préférence pas en contact avec la couche 18.

Le dispositif 10 comprend en outre une couche 30. La couche 30 est en un matériau isolant, par exemple en un nitrure, par exemple en un nitrure de silicium. La couche 30 recouvre, de préférence entièrement, la couche 28. La couche 30 s'étend donc sur les portions de la couche 28 recouvrant les parois des cavités 20, sur les portions de la couche 28 recouvrant les portions découvertes des pistes 14 et de l'empilement 12, et sur les portions de la couche 28 recouvrant la face supérieure de la couche 18. De préférence, la couche 30 recouvre uniquement la couche 28. Ainsi, la couche 30 n'est de préférence pas en contact avec la couche 18 ou avec les couches 24.

De préférence, des portions 31 de la couche 18 ne sont pas recouvertes des couches 26, 28, 30. Les portions 31 sont de préférence au moins partiellement en regard de pistes 14.

Le dispositif comprend un empilement 38 de couches isolantes 32, 34 et 36. La couche 32 constitue la couche inférieure de l'empilement 38. La couche 36 constitue la couche supérieure de l'empilement 38. La couche 34 constitue une couche interne ou intermédiaire de l'empilement 38.

La couche 32 repose sur la couche 18, sur la cellule 11 et sur la couche 30. Autrement dit, au moins une portion de la couche 18 est recouverte par, de préférence en contact avec, la face supérieure de la couche 32. La face supérieure de la couche 30 est recouverte, de préférence en contact avec, la couche 32. De préférence, la face supérieure de la couche 30 est entièrement recouverte, de préférence en contact avec, la couche 32. Les parois latérales des portions des couches 26, 28, 30 reposant sur la face supérieure de la couche 18 sont recouvertes, de préférence en contact avec la couche 32.

La couche 34 repose sur la face supérieure de la couche 32. La couche 34 est par exemple en contact avec la face supérieure de la couche 32.

La couche 36 repose sur la face supérieure de la couche 34. La couche 36 est par exemple en contact avec la face supérieure de la couche 34.

La couche 32 est par exemple en un oxyde, par exemple en oxyde de silicium. La couche 34 est par exemple en un nitrure, par exemple en nitrure de silicium. La couche 36 est par exemple en un oxyde, par exemple en oxyde de silicium.

Le dispositif 10 comprend des éléments de connexion, ou plots de connexion, 40. Les éléments 40 sont par exemple en métal, par exemple en cuivre. Les éléments 42 traversent les couches 16, 18, 32, 34 et 36 de manière à atteindre des pistes 14, de préférence les pistes 14 situées dans la couche supérieure de l'empilement 12. De préférence, chaque élément 42 est en contact avec une portion de la couche 28 située sur la face supérieure de la couche 18, de préférence entre deux groupes de lignes de cavités 20. Les éléments 40 sont par exemple reliées ensemble et aux couches 24 par les pistes conductrices 14. Les éléments 40 sont ainsi reliés à la première électrode de la cellule 11.

Le dispositif 10 comprend des éléments de connexion 42. Les éléments 42 sont par exemple en métal, par exemple en cuivre. Les éléments 42 sont en contact avec la couche 28. Plus précisément, chaque élément 42 traverse les couches 30, 32, 34 et 36 de manière à atteindre la couche 28. De préférence, chaque élément 42 est en contact avec une portion de la couche 28 située sur la face supérieure de la couche 18, de préférence entre deux groupes de lignes de cavités 20. Les éléments 42 sont ainsi reliés à la deuxième électrode de la cellule 11.

Les éléments 42 sont par exemple reliés entre eux par des pistes 44. Les pistes 44 sont par exemple en métal, par exemple en cuivre. Les pistes 44 s'étendent dans les couches 34 et 36. Par exemple, les pistes 44 s'étendent de la face inférieure de la couche 34 à la couche supérieure de la couche 36.

Lors du fonctionnement du dispositif 10, la cellule 11 peut être lue en déterminant la polarité électrique de la couche 26. La programmation de la cellule 11 est ainsi effectuée en appliquant la polarité voulue à la couche 26, par exemple en appliquant une tension adaptée aux électrodes de la cellule.

A titre de variante, le fond des cavités 20 peut être constitué de matériau isolant. La couche comprend par exemple des portions s'étendant sur la face supérieure de la couche 18. Le dispositif peut comprendre des éléments de connexion, par exemple des vias conducteurs isolés, atteignant les portions de la couche 24 s'étendant sur la face supérieure de la couche 18.

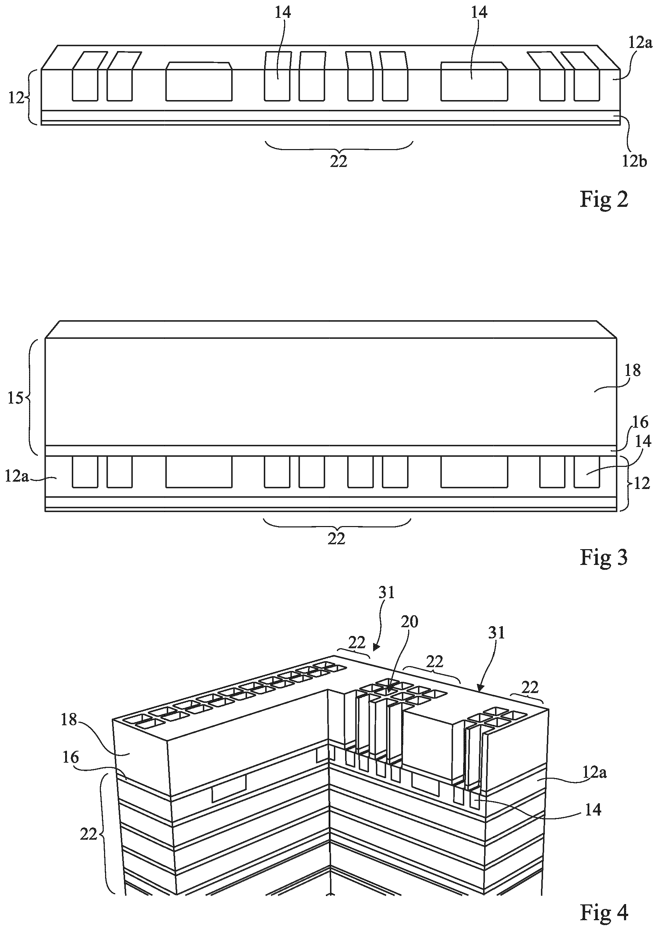

Les figures 2 à 9 illustrent des étapes, de préférence successives, d'un procédé de fabrication du mode de réalisation du dispositif des figures 1A, 1B et 1C.

La figure 2 représente une étape d'un procédé de fabrication du mode de réalisation des figures 1A, 1B et 1C.

Au cours de cette étape, l'empilement 12 et les pistes 14 sont formés. Autrement dit, les couches 12a et 12b sont formées les unes sur les autres de manière à obtenir une alternance de couches 12a et 12b. De préférence, la couche supérieure de l'empilement 12 est une couche 12a.

Les pistes 14 sont formées dans les couches 12a. Les pistes 14 de chaque couche 12a sont par exemple formées lors de la formation de la couche 12a.

La figure 3 représente une autre étape d'un procédé de fabrication du mode de réalisation des figures 1A, 1B et 1C.

Au cours de cette étape, l'empilement 15 est formé. Autrement dit, la couche 16 est formée sur, de préférence en contact avec, la face supérieure de la couche 12a supérieure de l'empilement 12 et sur, de préférence en contact avec, les faces supérieures des pistes 14 affleurant la face supérieure de la couche 12a supérieure de l'empilement 12. De préférence, la couche 16 est formée sur toute la face supérieure de la couche 12a supérieure de l'empilement 12 et sur toutes les faces supérieures des pistes 14 affleurant la face supérieure de la couche 12a supérieure de l'empilement 12.

De plus, la couche 18 est formée sur, de préférence en contact avec, la couche 16. De préférence, la couche 18 recouvre, de préférence est en contact avec, toute la couche 16, plus précisément toute la face supérieure de la couche 16.

La figure 4 représente une autre étape d'un procédé de fabrication du mode de réalisation des figures 1A, 1B et 1C.

Au cours de cette étape, les cavités 20 sont formées dans les couches 16 et 18. Plus précisément, les groupes 22 de lignes de cavités 20 sont formés dans les couches 16 et 18. Chaque cavité 20 découvre une portion d'une piste conductrice 14, de préférence une piste conductrice 14 située dans la couche 12a supérieure de l'empilement 12. De préférence, toutes les pistes 14 dont une portion est découverte par les cavités 20 sont reliées entre elles, par exemple par des pistes 14 situées dans une ou plusieurs couches de l'empilement 12.

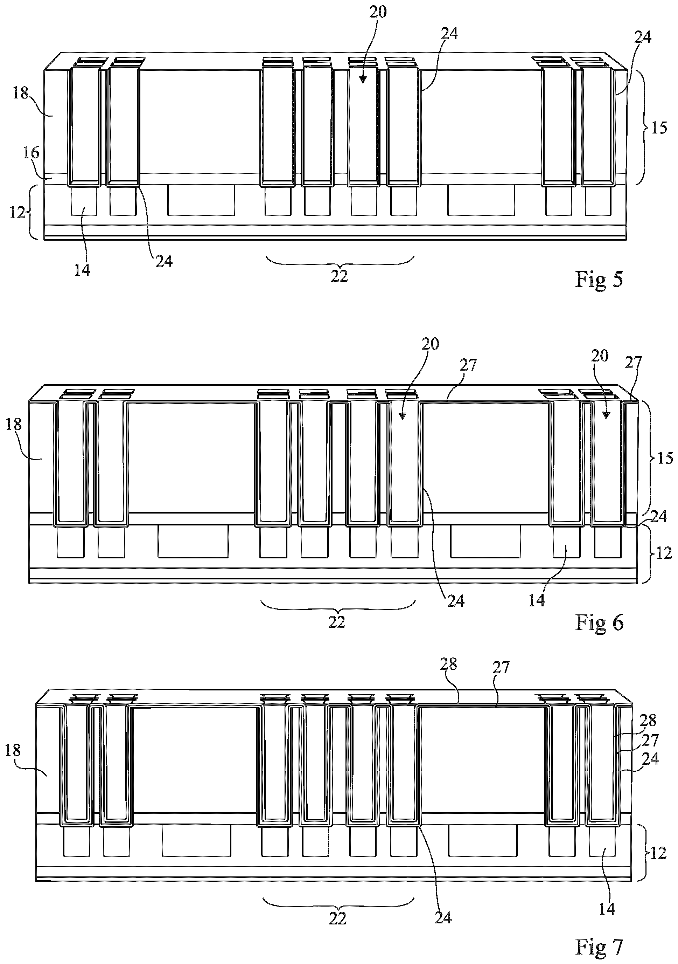

La figure 5 représente une autre étape d'un procédé de fabrication du mode de réalisation des figures 1A, 1B et 1C.

Au cours de cette étape, les couches 24 sont formées. Plus précisément, une couche 24 est formée dans chaque cavité 20.

Par exemple, la formation des couches 24 comprend la formation d'une couche non représentée en le matériau des couches 24. Ladite couche est formée de manière à avoir une épaisseur sensiblement égale à l'épaisseur des couches 24. Ladite couche est formée de manière conforme sur la structure résultant de l'étape de la figure 4. Ladite couche recouvre les parois et le fond des cavités formées par les cavités 20. En particulier, la portion d'une piste 14 située au fond de la cavité est entièrement recouverte par la couche 24. Ainsi, les pistes 14 sont entièrement recouverte par la couche 18 ou les couches 24.

La couche 24 est de préférence formée par un procédé de dépôt de couches atomique ou ALD (Atomic Layer Déposition). Un tel procédé permet de déposer des couches ayant des épaisseurs de quelques nanomètres par utilisation de gaz, ce qui permet de former des couches conformes recouvrant entièrement les surfaces découvertes. En particulier, il est ainsi possible de recouvrir entièrement les portions des pistes 14 découvertes. De plus, un tel procédé permet un bon contrôle de la concentration de dopants et peut être utilisé dans des procédé de type "Back end". Les portions de ladite couche situées en dehors des cavités 20 sont ensuite retirées.

La figure 6 représente une autre étape d'un procédé de fabrication du mode de réalisation des figures 1A, 1B et 1C.

Au cours de cette étape, une couche 27 est formée. Plus précisément, la couche 27 est formée de manière conforme sur l'ensemble de la structure résultant de l'étape de la figure 5. La couche 27 recouvre les couches 24. Autrement dit, la couche 27 s'étend sur les parois et le fond de la cavité formée par chaque cavité 20. La couche 27 s'étend en outre sur la face supérieure de la couche 18.

La couche 27 est en un matériau diélectrique pouvant être rendu ferroélectrique par une étape de recuit. La couche 27 est par exemple en oxyde d'hafnium (HfO2) dopé par du silicium, par exemple avec une proportion de silicium comprise entre 0,5 % et 5%. La couche 27 peut, alternativement, être en HfZrO2.

La figure 7 représente une autre étape d'un procédé de fabrication du mode de réalisation des figures 1A, 1B et 1C.

Au cours de cette étape, la couche 28 est formée. Plus précisément, la couche 28 est formée de manière conforme sur l'ensemble de la structure résultant de l'étape de la figure 6. La couche 28 recouvre la couche 27. Ainsi, la couche 28 s'étend sur les parois et le fond de la cavité formée par chaque cavité, ainsi que la face supérieure de la couche 18. En particulier, la couche 28 recouvre entièrement la portion de la couche 27 correspondant à la couche 26 de la cellule 11.

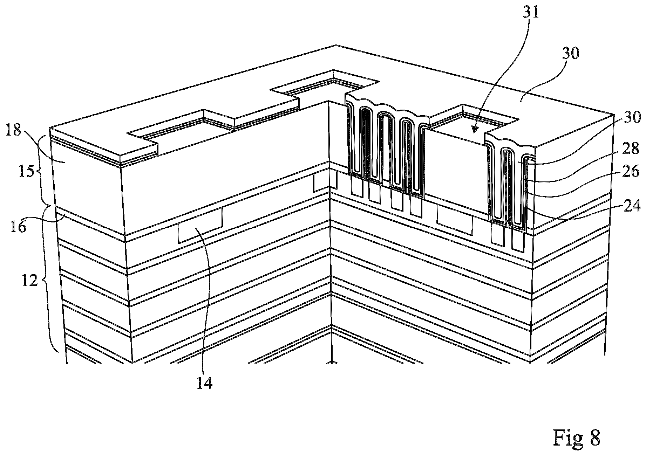

La figure 8 représente une autre étape d'un procédé de fabrication du mode de réalisation des figures 1A, 1B et 1C.

Au cours de cette étape, la couche 30 est formée sur l'ensemble de la structure résultant de l'étape 7. La couche 30 est par exemple suffisamment épaisse pour remplir les cavités 20.

L'étape de la figure 8 comprend aussi une étape de recuit de la structure formant la couche 26. Plus précisément, l'étape de la figure 8 comprend le recuit des portions de la couche 27 correspondant à la couche 26 de la cellule 11. L'étape de recuit permet de rendre ferroélectrique les portions de la couche 27 correspondant à la couche 26 de la cellule 11.

L'étape de recuit est effectuée par l'application d'un laser sur l'ensemble de la structure, en particulier sur la portion de la couche 27 correspondant aux couches 26. La longueur d'onde du laser, le matériau de la couche 28 et l'épaisseur de la couche 28 sont choisis de telle manière que la couche 28 absorbe le laser et chauffe, notamment par diffusion, la couche 27 située en contact avec les portions de la couche 28 ayant absorbé le laser. De préférence, le laser est entièrement absorbé par la couche 28. De préférence, la couche 27 est chauffée à une température locale supérieure à 400 °C, par exemple supérieure à 500 °C.

La longueur d'onde du laser est par exemple inférieure à 1100 nm, par exemple inférieure à 400 nm, par exemple inférieure à 360 nm, par exemple égale à 308 nm. Par exemple, pour une longueur d'onde égale à 308 nm, une couche 28 en nitrure de titane ayant une épaisseur comprise entre 20 nm et 30 nm permet d'absorber entièrement le laser et de rendre ferroélectrique les portions de la couche 27 correspondant à la couche 26.

Selon un mode de réalisation, le laser est configuré pour avoir des dimensions et une forme connue et pour n'atteindre que l'emplacement de la cellule 11, c'est-à-dire les portions de la couche 28 situées en contact avec les portions de la couche 27 correspondant à la couche 26.

Selon un autre mode de réalisation, le laser est configuré pour avoir des dimensions permettant d'atteindre l'emplacement de la cellule 11 et au moins une partie de la structure entourant l'emplacement de la cellule. Par exemple, le laser est configuré pour être appliqué à l'ensemble du dispositif. L'étape de recuit comprend alors la formation d'un masque de protection recouvrant au moins ladite portion, par exemple l'ensemble du dispositif, de telle manière que le laser soit réfléchi sur le masque et n'atteigne que l'emplacement de la cellule.

Le matériau de la couche 30 est configuré pour être transparent à la longueur d'onde du laser. La couche est par exemple du nitrure de silicium.

De préférence, le laser est appliqué sur la structure sous la forme d'impulsions courtes, de manière à ne pas chauffer et à ne pas endommager les métaux de la structure, en particulier le matériau de la couche 24. Les impulsions ont par exemple une durée inférieure à 1 ps, par exemple inférieure à 200 ns, par exemple inférieure à 100 ns.

La puissance des impulsions et leur durée dépend par exemple des dimensions des cavités 20. Par exemple, les cavités 20 ont une hauteur inférieure à 600 nm, et des dimensions dans le plan de la face supérieure de la couche 18 inférieures à 170 nm, par exemple inférieures à 100 nm. Si les cavités 20 ont des dimensions supérieures, la puissance du laser permettant de rendre ferroélectrique l'ensemble de la couche 26 entrainerait des dommages sur le reste de la structure.

L'empilement des couches 26, 28 et 30 est ensuite gravé au niveau des emplacements 31. Autrement dit, une portion de l'empilement des couches 26, 28 et 30 est gravée entre chaque groupe 22 de lignes de cavités 20. Ainsi, au niveau des emplacements 31, les couches 26, 28 et 30 sont gravées de manière à découvrir la couche 18.

Les portions de la couche 30 situées en regard des cavités ou dans les cavités ne sont pas gravées.

Chacun des emplacements 31 est situé en regard d'une piste 14. Lesdites pistes 14 sont de préférence reliées entre elles. Lesdites pistes 14 ne sont de préférence pas reliées aux pistes 14 étant en contact avec les couches 24.

Le procédé de fabrication du mode de réalisation de la figure 1 comprend des étapes postérieures à l'étape de la figure 8. Au cours de ces étapes, l'empilement 38 de couches isolantes est formé sur la structure résultant de l'étape de la figure 8 et les éléments 40, 42 et 44 de connexion sont formés.

A titre de variante, l'étape de recuit peut être effectuée entre l'étape de formation de la couche 28 et l'étape de formation de la couche 30.

De manière plus générale, l'étape de recuit est effectuée alors que la couche 28 recouvre entièrement la structure, c'est-à-dire avant une étape de gravure de la couche 28, de manière à protéger les structures sous-jacentes du laser, en particulier les structures en cuivre, par exemple les pistes 14. Ainsi, les étapes des figures 7 et 8 peuvent comprendre, dans cet ordre, soit la formation de la couche 28, la formation de la couche 30 et le recuit soit la formation de la couche 28, le recuit et la formation de la couche 30.

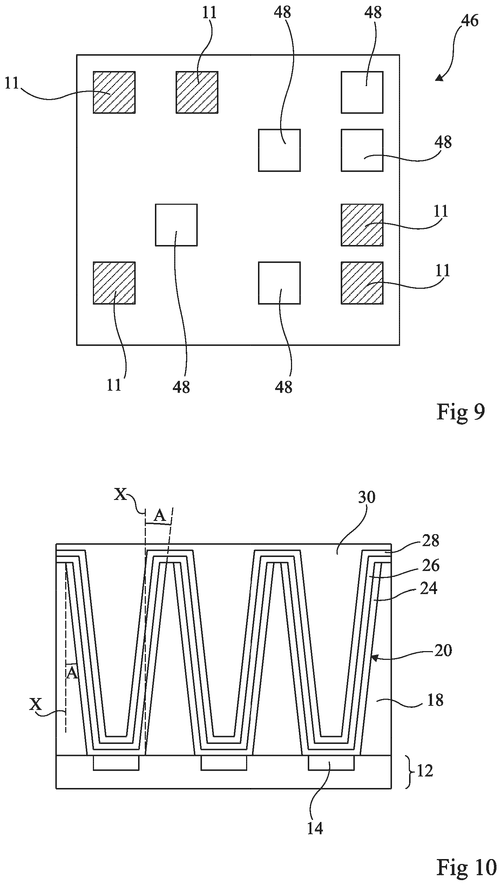

La figure 9 représente schématiquement une vue de dessus d'un dispositif 46 comprenant des cellules 11 telles que décrites en relation avec les figures 1A, 1B et 1C.

Plus précisément, le dispositif 46 comprend des cellules mémoire non volatile 11 et des cellules mémoire volatile 48.

Les condensateurs 48 sont des condensateurs de type métal-oxyde-métal (MOM). Les condensateurs 48 sont chacun constitués des couches 24, 26, 28, la couche 26 n'ayant pas subi l'étape de recuit à l'emplacement du condensateur 48.

Plus précisément, le procédé de fabrication du dispositif 46 comprend les étapes des figures 2 à 8, l'étape de recuit étant effectuée de manière que seuls les emplacements des cellules 11 subissent l'étape de recuit. Les condensateurs 48 sont obtenus par les étapes des figures 2 à 8 à l'exception de l'étape de recuit. Les condensateurs 48 et les cellules 11 sont par exemple formés simultanément, les étapes des figures 2 à 8 autres que le recuit étant effectuées simultanément pour au moins une partie des cellules 11 et des condensateurs 48, de préférence pour toutes les cellules 11 et tous les condensateurs 48.

Les condensateurs 48 et les cellules 11 sont par exemple situées dans un même niveau, par exemple dans le même empilement 15.

Au moins certains des condensateurs 48 et au moins certaines des cellules 11 sont par exemple situés dans une même région. Ainsi, un condensateur 48 peut être situé entre deux cellules 11 et une cellule 11 peut être située entre deux condensateurs 48.

La figure 10 représente un autre mode de réalisation d'un dispositif électronique. Plus précisément, la figure 10 représente une partie d'une cellule 11 selon une variante. La figure 10 représente une vue en coupe d'une cellule 11.

La cellule 11 diffère de la cellule 11 des figures 1A à 1C en ce que, contrairement à la cellule des figures 1A à 1C, les parois latérales des cavités 20 de la cellule 11 ne sont pas verticales, c'est-à-dire ne sont pas perpendiculaires à un axe horizontal, c'est-à-dire ne sont pas perpendiculaires au plan de la face supérieure du support 12.

Les parois latérales des cavités 20 de la cellule 11 de la figure 10 sont penchées. Plus précisément, les parois latérales des cavités 20 sont penchées vers l'extérieur. Autrement dit, la surface de l'ouverture de la cavité est supérieure à la surface du fond de la cavité. De préférence, toutes les parois de chaque cavité 20 sont penchées. Chaque paroi latérale forme avec un axe X vertical, c'est à dire un axe X orthogonal au plan de la face supérieure du support 12, un angle A. L'angle A est de préférence compris entre 0,5 ° et 10 °, par exemple entre 0,5 ° et 5 °.

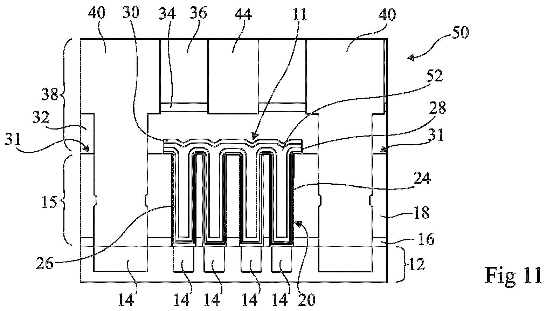

La figure 11 représente un autre mode de réalisation d'un dispositif électronique 50. Plus précisément, la figure 11 représente une vue en coupe d'un mode de réalisation du dispositif 50 selon le même plan que la figure 1B.

Le dispositif 50 comprend les éléments du dispositif 10 des figures 1A à 1C. Ainsi, le dispositif 50 comprend :
- le support 12, dans lequel sont situées les pistes conductrices 14 ;
- les couches isolantes 16 et 18 ;
- les cavités 20 ;
- les couches 24, 26, 28, situées dans les cavités 20 ;
- les couches isolantes 30, 32, 34, 36 ;
- les éléments conducteurs 40 ; et
- les pistes conductrices 44.

Le dispositif 50 diffère du dispositif 10 en ce que le dispositif 50 comprend une couche 52 entre la couche 28 et la couche 30. La couche 52 est une couche conductrice, par exemple en métal, par exemple en tungstène. La couche 52 est par exemple en un matériau différent de la couche 28.

La couche 52 recouvre, de préférence entièrement, la couche 28. La couche 52 s'étend donc sur les portions de la couche 28 recouvrant les parois des cavités 20, sur les portions de la couche 28 recouvrant les portions découvertes des pistes 14 et de l'empilement 12, et sur les portions de la couche 28 recouvrant la face supérieure de la couche 18. La couche 52 remplit par exemple les cavités 20. De préférence, la couche 52 recouvre uniquement la couche 28. Ainsi, la couche 52 n'est de préférence pas en contact avec la couche 18 ou avec les couches 24.

Le dispositif 50 comprend, comme le dispositif 10 des figures 1A à 1C, la couche 30. La couche 30 du dispositif 50 diffère de la couche 30 du dispositif 10 en ce que la couche 30 recouvre la couche 52. Ainsi, la couche 30 n'est par exemple pas située dans les cavités 20. La couche 30 repose ainsi sur la couche 52, de préférence uniquement sur la couche 52. La couche 30 est ainsi séparée de la couche 28 par la couche 52. Comme en figures 1A à 1C, la couche 30 n'est de préférence pas en contact avec les couches 24, 26, 28 ou avec la couche 18.

Le procédé de fabrication du dispositif 50 diffère du procédé de fabrication du dispositif 10 en ce que le procédé comprend, en outre la formation de la couche 52 entre la formation de la couche 28 et la formation de la couche 30. Les couches 28, 52, 30 sont par exemple gravées lors de la même étape de gravure.

L'étape de recuit, correspondant par exemple à l'étape de la figure 6, est par exemple effectuée après dépôt de la couche 28, après le dépôt des couches 52 et 28, ou après le dépôt de la couche 30.

Le mode de réalisation de la figure 11 peut par exemple être combiné au mode de réalisation de la figure 10. Ainsi, les parois des cavités 20 du dispositif 50 peuvent être inclinées, comme décrit en relation avec la figure 10.

Un avantage des modes de réalisation décrits est qu'il est possible de former des cellules mémoire non volatile ferroélectrique.

Un autre avantage des modes de réalisation décrits est qu'il est possible de former simultanément des cellules mémoire et des condensateurs.

Un autre avantage des modes de réalisation décrits est que la formation des cellules ne comprend qu'une étape supplémentaire par rapport à la formation des condensateurs.

Un avantage du mode de réalisation de la figure 11 est que le laser atteint plus facilement, durant l'étape de recuit, les portions de la couche 27 s'étendant sur les parois latérales de la cavité 20. La puissance du laser peut ainsi être inférieure à la puissance utilisée dans le cas où les parois sont verticales. Il y a donc moins de risque d'endommager la structure.

Un avantage du mode de réalisation de la figure 11 est qu'il permet de chauffer, et donc de rendre ferroélectrique, de façon plus homogène la couche 27, ou la couche 26, grâce à une conduction améliorée de la chaleur par la couche 52 qui remplit la cavité 20.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif électronique (10, 46), le procédé comprenant :
- la formation d'un support (12) comprenant au moins une première couche isolante (12a) dans laquelle sont situées des pistes conductrices (14) ;
- la formation d'une deuxième couche isolante (18) sur le support (12) ;
- la formation de cavités (20) dans la deuxième couche isolante (18) ; et
- la formation d'une cellule mémoire dans un premier emplacement comprenant :
o la formation d'un empilement de couches, l'empilement s'étendant sur les parois et le fond des cavités (20), l'empilement comprenant une couche (26) en un matériau apte à devenir ferroélectrique situé entre une première couche conductrice (24) et une deuxième couche conductrice (28), la formation de l'empilement comprenant la formation des première (24) et deuxième (28) couches conductrices et d'une couche diélectrique (27) entre les première (24) et deuxième (28) couches conductrices ;
o l'application d'un laser sur l'empilement de couches à au moins le premier emplacement de sorte à activer des propriétés ferroélectriques de la couche en un matériau apte à devenir ferroélectrique (26);
- la formation d'une couche recouvrant la deuxième couche conductrice (28), ladite couche étant :
- une couche protectrice (30), l'étape d'application du laser étant effectuée après la formation de la couche protectrice (30) ; ou
- une troisième couche conductrice (52), la troisième couche conductrice (52) remplissant les cavités (20).

2. Procédé selon la revendication 1, dans lequel le laser est appliqué uniquement sur le premier emplacement.

3. Procédé selon la revendication 1, dans lequel le laser est appliqué à l'ensemble du dispositif, des portions de la deuxième couche conductrice (28) entourant le premier emplacement étant protégées, lors de l'application du laser, par un masque de protection.

4. Procédé selon l'une quelconque des revendications 1 à 3, dans lequel, lors de l'application du laser, la couche diélectrique (27) est entièrement recouverte par la deuxième couche conductrice (28).

5. Procédé selon l'une quelconque des revendications 1 à 4, dans lequel la couche protectrice (30) est transparente à la longueur d'onde du laser.

6. Procédé selon l'une quelconque des revendications 1 à 5, dans lequel la deuxième couche conductrice (28) a une épaisseur strictement supérieure à 1 nm, par exemple supérieure ou égale à 3 nm, par exemple comprise entre 3 nm et 20 nm, la deuxième couche étant en un matériau autorisant l'absorption entière de l'énergie du laser de manière à chauffer la couche diélectrique (27) par diffusion.

7. Procédé selon la revendication 6, dans lequel la couche diélectrique (27) est chauffée à une température supérieure à 500 °C.

8. Procédé selon l'une quelconque des revendications 1 à 7, dans lequel le laser est appliqué par impulsion d'une durée inférieure à 1 ps.

9. Procédé selon l'une quelconque des revendications 1 à 8, dans lequel le laser a une longueur d'onde inférieure à 400 nm.

10. Procédé selon l'une quelconque des revendications 1 à 9, dans lequel le procédé comprend la fabrication d'au moins un condensateur dans un deuxième emplacement, le condensateur comprenant les première (24) et deuxième (28) couches conductrices et la couche diélectrique (27), le laser n'étant pas appliqué à la couche diélectrique (27) dans le deuxième emplacement.

11. Procédé selon l'une quelconque des revendications 1 à 10, dans lequel les parois latérales des cavités (20) sont penchées et forment chacune un angle compris entre 0,5° et 5° avec une direction orthogonale au plan du fond des cavités.

12. Procédé selon l'une quelconque des revendications 1 à 11, dans lequel la couche en un matériau ferroélectrique (26) est en oxyde d'hafnium ou en HzZrO2.

13. Procédé selon l'une quelconque des revendications 1 à 12, dans lequel la couche en un matériau ferroélectrique (26) est en oxyde d'hafnium dopé par du silicium, la proportion de silicium étant comprise entre 0,5 % et 5%.

14. Procédé selon l'une quelconque des revendications 1 à 13, dans lequel la première couche conductrice (24) est en nitrure de titane dopé silicium.

15. Dispositif électronique (10, 46) comprenant :
- un support (12) comprenant au moins une première couche isolante (12a) dans laquelle sont situées des pistes conductrices (14), et une deuxième couche isolante (18) comprenant des cavités (20) ;
- une cellule mémoire comprenant un empilement de couches, l'empilement s'étendant sur les parois et le fond des cavités (20), l'empilement comprenant une couche (26) en un matériau ferroélectrique située entre une première couche conductrice (24) et une deuxième couche conductrice (28), la deuxième couche conductrice (28) étant continue et entièrement métallique ; et
- une couche recouvrant la deuxième couche conductrice (28), ladite couche étant :
- une couche protectrice (30) ; ou
- une troisième couche conductrice (52), la troisième couche conductrice (52) remplissant les cavités (20).

16. Dispositif selon la revendication 15, le dispositif comprenant un condensateur comprenant un empilement de couches, l'empilement s'étendant sur les parois et le fond des cavités (20), l'empilement comprenant une couche en un matériau apte à devenir ferroélectrique située entre une première couche conductrice et une deuxième couche conductrice, la deuxième couche conductrice étant continue et entièrement métallique.
